# EUROPÄISCHE PATENTSCHRIFT

(11) **EP 2 078 963 B1**
(45) Veröffentlichungstag und Bekanntmachung des Hinweises auf die Patenterteilung: **25.07.2018**
(21) Anmeldenummer: 08021984.3
(22) Anmeldetag: 18.12.2008
(51) Int. Cl.: G01R 15/12, G01R 1/04, G01D 11/24

(54) **Prüfgerät**
Testing device
Appareil de contrôle

(30) Priorität: 09.01.2008 DE 102008003586
(43) Veröffentlichungstag der Anmeldung: 15.07.2009
(73) Patentinhaber: GMC-I Messtechnik GmbH, 90449 Nürnberg (DE)
(72) Erfinder: Burger, Stefan, 90766 Fürth (DE); Kühnel, Wolfgang, 92334 Berching (DE)
(74) Vertreter: Kohl, Fabian Hanno

(56) Entgegenhaltungen:
- EP-A- 0 100 950
- EP-A- 0 644 428
- EP-A1- 0 100 949
- EP-A2- 1 760 999
- DE-A1- 2 636 079
- DE-A1- 4 210 526
- JP-A- 10 173 747
- US-A- 4 439 726
- US-A1- 2004 012 379
- US-A1- 2005 221 865

## Beschreibung

Die Erfindung/Neuerung betrifft ein Prüfgerät zum Messen von Spannungen, Strömen und dergleichen, aufweisend ein mit einer Anzeigeeinheit versehenes Kopfteil sowie ein Basisteil, das wenigstens eine Anschluss- und/oder eine Schnittstelle zum Einleiten eines Messstroms umfasst.

Aus dem Stand der Technik sind Messgeräte bekannt, die zwischen dem die Anzeigeeinheit umfassenden Gehäuse und einem weiteren Gehäuseteil verschwenkbar sind.

DE 42 10 526 A1 lehrt eine Vorrichtung zur Übertragung von Daten zwischen einer Messwerterfassungseinheit und einer Messwertverarbeitungseinheit, wobei eine Hilfseinheit verwendet wird, die ein Verbundteil besitzt, das so gestaltet ist, dass zwischen ihr und der Messwerterfassungseinheit eine mechanisch lösbare Verbindung entsteht. Die Hilfseinheit ist so aufgebaut und zu der Messwerterfassungseinheit so angeordnet, dass zur kontaktlosen Koppelung vorgesehene Kopplungselemente in einem definierten Abstand miteinander korrespondieren. Die von der Messwerterfassungseinheit kommenden Messdaten können so über die Hilfseinheit zur Messwertverarbeitungseinheit weitergegeben werden.

EP 644 428 A2 lehrt eine Gehäusestruktur für ein Oszilloskop, wobei eine Haupteinheit des Oszilloskops horizontal platziert ist und ein Display in einem passenden Winkel anpassbar ist. Das das Display umfassende Kopfteil ist hierbei in einem unteren Bereich konvex und die Haupteinheit mit einer entsprechenden konkaven Ausformung ausgebildet. EP 0 100 949 A1 und EP 100 950 A1 lehren jeweils eine tragbare Messvorrichtung umfassend ein Messgerät, Messleitungen und Messspitzen, wobei das Messgerät mit Hilfe eines Traggurtes um den Hals gehängt werden kann, sodass die Hände des Bedieners für die Messung frei sind. Ferner sieht die Erfindung gemäß beider Dokumente jeweils vor, dass die bisher störend von dem Messgerät herabhängende Messleitungen über den Traggurt oder einen Teilbereich des Traggurtes geführt sind.

US 4 439 726 A lehrt ein Messgerät, dessen Bedienung dadurch erleichtert wird, dass im Bereich der Bedienebene ein Drucktaster angebracht ist, der bei einem Zusammenklappen der Baugruppen das Messgerät (z. B. den Verstärkerteil) automatisch abschaltet. Diese automatische Abschaltung des geöffneten Gerätes kann auch durch Drehen oder Schieben eines Tasters realisiert werden.

US 2005/0221865 A1 und EP 1 760 999 A2 lehren jeweils ein klappbares Mobiltelefon mit einem Kopfteil sowie einem Basisteil, wobei das Kopfteil und das Basisteil zueinander schwenkbeweglich gelagert sind und die Schwenkachse sowohl durch das Basisteil als auch durch das Kopfteil verläuft und wobei die Drehachse eines Drehwahlschalters koaxial zur Schwenkachse des Kopf- und Basisteils verläuft.

Der Erfindung liegt die Aufgabe zugrunde, ein Prüfgerät mit den Merkmalen des Oberbegriffs des Anspruches 1 derart weiterzubilden, dass insbesondere die Baugröße eines mit schwenkbaren Gehäuseteilen versehenen Prüfgerät verringert wird. Ferner ist es Aufgabe der Erfindung diesen Schwenkmechanismus auf mechanisch einfache Weise, einer geringen Anzahl an Bauteilen sowie mit einfachen Mitteln zur Umgebung hin abdichtbar auszugestalten. Darüber hinaus ist es ebenfalls Aufgabe der Erfindung die Handhabung der Bedienelemente möglichst einfach und unabhängig von der jeweiligen Schwenkstellung der Gehäuseteile des Prüfgerätes auszugestalten.

Diese Aufgabe wird durch die kennzeichnenden Merkmale des Anspruches 1 gelöst. Vorteilhafte Weiterbildung der Erfindung ergeben sich aus den Unteransprüchen 2-14.

Als Kern der Erfindung wird es angesehen, dass das Kopfteil und das Basisteil zueinander schwenkbeweglich gelagert sind und die Schwenkachse zumindest bereichsweise sowohl durch das Basisteil als auch durch das Kopfteil verläuft, wobei die Drehachse eines Drehwahlschalters koaxial zur Schwenkachse des Kopf- und Basisteils verläuft und mit dem Drehwahlschalter die zu messende Messgröße auswählbar ist. Insbesondere dann, wenn die Schwenkachse zumindest bereichsweise durch das Gehäuse des Basisteils als auch durch das Gehäuse des Kopfteils verläuft, können mittels der "zusammengeschobenen Konstruktion" geringere Mindestabmaße zumindest in der Längserstreckung des Prüfgerätes erreicht werden, da der Schwenkmechanismus nicht mehr an den beiden zueinander weisenden Gehäuseendseiten des Kopf- und Basisteils angebaut ist, sondern durch eine unwesentlich in die Breite des Prüfgerätes aufbauende Lagerung der beiden Prüfgerätgehäuseteile ermöglicht wird.

In einer vorteilhaften Ausführungsform weist das Kopfteil und/oder das Basisteil eine u-förmige Ausnehmung zur Aufnehmung des Basis- oder Kopfteils auf. Beispielsweise ist das Basisteil mit einer u-förmigen Ausnehmung versehen, in die die Gehäusehälften des Kopfteils aufgenommen sind und im Bereich der Schenkel der u-förmigen Ausnehmung mit dem Basisteil drehbeweglich verbunden sind. Selbstverständlich ist auch eine Umkehr dieses Prinzips ebenso vorteilhaft, bei der das das Anzeigeelement umfassende Kopfteil eine u-förmige Ausnehmung aufweist, in die zumindest ein Bereich des Basisteils aufgenommen ist. Besonders die u-förmige Konstruktion, bei der die Schwenkachse von Kopf- und Basisteil durch die Schenkel der u-förmigen Ausnehmung verläuft, gewährleistet eine mechanisch sowohl robuste, als auch zuverlässige Drehverbindung der beiden Prüfgerätteile.

Eine weitere vorteilhafte Maßnahme ist es, wenn das Kopf- oder Basisteil in wenigstens eine den Kopf- oder Basisteil zugeordneten Seite einen konvexen Gehäusebereich aufweist. In diesem Zusammenhang kann dem konvexen Gehäusebereich ein zumindest bereichsweise entsprechender konkaver Gehäusebereich an dem dem konvexen Gehäusebereich gegenüberstehenden Kopf- oder Basisteil zugeordnet sein. Dadurch, dass die beiden Gehäuseteile lediglich eine rotatorische Relativbewegung zueinander ausführen, kann die Gestaltung der im Wesentlichen parallel zur Schwenkachse verlaufenden zueinander gerichteten

Gehäuseflächen in konvexer und konkaver Form eine sehr kompakte Ausführung eines Prüfgerätes realisiert werden, da der für die Rotationsbewegung benötigte Freiraum zwischen den beiden Gehäuseteilen über zumindest einen Schwenkbereich der beiden Gehäuseteile sehr gering gehalten werden kann.

In einer vorteilhaften Ausführungsform ist die Schwenkachse im Wesentlichen rechtwinklig zur Längsachse des Prüfgerätes und kann an zwei zueinander weisenden Endbereichen des Kopf- und/oder Basisteils angeordnet sein. Eine derartige Konstruktion unterstützt eine kompakte Bauweise des Prüfgerätes, da für das Kopfteil lediglich ein kurzes Quersegment benötigt wird und sich dieses somit nicht über die gesamte Längsachse des Prüfgerätes erstrecken muss.

Im Übrigen sei noch darauf hingewiesen, dass das Kopfteil einen von einer reinen rotationssymmetrischen Form abweichenden, eine Anzeigeeinheit umfassenden Teilbereich aufweisen kann, der durch die Drehbewegung des Kopfteils relativ zum Basisteil aus der Haupterstreckungsebene des Basisteils herausschwenkbar ist. Beispielsweise kann das Kopfteil eine im Wesentlichen zylinder- oder tonnenartige Form aufweisen, aus der eine im Querschnitt tangential an dem Umfang des zylinder- bzw. tonnenartigen Gehäuses angeordnete Anzeigeeinheit ausgebildet ist. In diesem Zusammenhang können mit der erfindungsgemäßen Ausführungsform wenigstens drei Arbeitspositionen (Schwenkpositionen des Basisteils relativ zum Kopfteil) realisiert werden. In einer ersten Position liegt das Basisteil auf dem Rücken und das Kopfteil schließt mit seiner Anzeigeeinheit einen Winkel von 0 - 180° (vorzugsweise 80 - 145°) ein. In dieser ersten Tischstellung (Tischstellung I) weisen die beispielsweise vom Kopfteil gegenüberliegenden Schnittstellen des Basisteils zum Einleiten eines Messstromes zum Bediener hin und das Kopfteil ist in einer entfernteren Position. Durch eine vertikale Aufstellung des Prüfgerätes, das beispielsweise an seinem oberen Stirnbereich Aufnahmen für Schlaufen aufweist, mittels derer das Prüfgerät von einer Bedienperson umgehängt und getragen werden kann, ist das Kopfteil zum Kopf des Bedieners gerichtet und weist dabei eine Verschwenkung des Kopfteils relativ zum Basisteil um einen Winkel von 180 - 270° (vorzugsweise 190 - 255°) auf. Dies ermöglicht für eine komfortable Ablesung und Bedienung des Prüfgerätes (Tragestellung). Insbesondere durch die erfindungsgemäße schwenkbewegliche Lagerung von Kopf- und Basisteil wird die Verschwenkung in einen Winkelbereich von 270 - 360° (vorzugsweise 270 - 250°) realisierbar. In einer derart verschwenkten Position (Tischstellung II) kann das Basisteil auf dessen "Bauch" gelegt werden, so dass die Schnittstellen zum Einleiten eines Messstroms vom Bediener weg weisen und die Kopfeinheit bzw. die Anzeigeeinheit und gegebenenfalls am Kopfbereich angeordnete Bedienelemente einen geringeren Abstand zu der Bedienperson aufweisen, was wiederum die Ablesbarkeit und Bedienung der Bedienelemente erleichtert. Insbesondere kurzsichtige Personen sind in der Lage nun die Anzeigeeinheit ohne große Anstrengung abzulesen.

Um die Bedienung der Gesamtvorrichtung weiter zu vereinfachen, ist es vorgesehen, einen Drehwahlschalter vorzusehen, der im Bereich des Kopfteils angeordnet ist. Der Drehwahlschalter kann sowohl an dem Kopfteil als auch am Basisteil angeordnet sein. Der Drehwahlschalter vereinfacht die Bedienung des Prüfgerätes. Erfindungsgemäß kann mit seiner Hilfe die zu messende Messgröße ausgewählt werden und mit weiteren Bedienelementen wie beispielsweise Tastern ein gezielter Messbereich ausgewählt werden.

Zur Verbesserung der Ergonomie des Prüfgerätes und um die "blinde Bedienung" des Prüfgerätes zu vereinfachen, ist es vorteilhaft, wenn die Drehachse des Drehwahlschalters koaxial zur Schwenkachse des Kopf- und Basisteils verläuft. Ein entscheidender Vorteil bei einer derartigen Konstruktion ist es, dass unabhängig von der Schwenkposition des Kopfteils zu dem Basisteil die räumliche Position des Drehwahlschalters konstant bleibt, da er nicht mit dem verschwenkten Kopfteil "mitwandert". Bei Verschwenken des Kopfteils relativ zum Basisteil führt der Drehwahlschalter ausschließlich rotatorische und keine translatorische Bewegungsanteile aus.

Weitere vorteilhafte Maßnahmen bezüglich des Drehwahlschalters sind, diesen im Bereich der Drehlagerung des Drehwahlschalters mit Dichtelementen zu versehen, um das Prüfgerät zumindest spritzwasserdicht (IP40) oder strengeren Dichtheitsklassifizierungen zugänglich zu machen. Auch eine derartige Auslegung des Drehwahlschalters, dass dieser in axialer und/oder radialer Richtung nach Art eines Tasters betätigbar ist, fördert die Ergonomie sowie eine einfachere, intuitive Bedienung des Messgerätes. Beispielsweise kann durch die Tasterfunktion des Drehwahlschalters ein Bestätigungswille des Bedieners der Elektronik bzw. der Software übermittelt werden.

Eine weitere die Bedienbarkeit erleichternde Ausbildung sieht vor, dass abhängig von der Schwenkstellung des Kopfteils relativ zum Basisteil wenigstens zwei unterschiedliche Display-Menü-Einstellungen voreingestellt ausgebbar sind.

Dies bedenkt, dass entweder werksseitig festgelegt und/oder vom Anwender selbst programmierbar z.B. den oben beschriebenen drei Schwenkstellungen (Tischstellung I, Tischstellung II, Tragestellung) jeweilige Menüs im Display ausgegeben werden. So kann eine bevorzugt im Labor angewendetes Menü (Prüfgeräteeinstellung) für eine Verschwenkung gemäß Tischstellung I und II angezeigt werden und bei einer Verschwenkung gemäß Tragestellung ein anderes im mobilen Betrieb bevorzugt verwendetes Menü automatisch durch die Verschwenkung angezeigt werden.

Um die Sicherheit, Bedien- und Stromversorgungsmöglichkeiten des Prüfgerätes positiv zu beeinflussen, ist es vorteilhaft, wenn zumindest ein Teil der für die Strom- bzw. Spannungsmessungen notwendigen Informationen über eine induktive Kopplung, insbesondere durch Transformatoren kabellos von dem Basisteil zum Kopfteil und umgekehrt übertragbar sind. Durch eine derartige Kopplung, bei der beispielsweise die Leistungs-/Messströme im Basisteil gemessen werden und über eine kabellose Kopplung die Leistungs-/Messströme betreffende Informationen zum Kopfteil übertragen und dort von Rechen-, Anzeige- und/oder Bedienelemente bearbeitet und gegebenenfalls veranschaulicht werden, kann die Gerätesicherheit positiv beeinflusst werden, da insbesondere die mit der Bedienperson in Kontakt tretenden im Kopfteil angeordneten Gehäuse- und Bedienelemente des Prüfgerätes nicht mit dem Leistungs-/Messstrom in Kontakt stehen. Dies ermöglicht ferner das Vorsehen von weiteren Schnittstellen im Bereich des Kopfteils des Prüfgerätes um beispielsweise Datenein- oder -auslesegeräte anzuschließen und/oder das Prüfgerät durch ein Netzteil während dessen Einsatz mit einer Netzspannung zu speisen und/oder im Prüfgerät eingesetzte Akkumulatoren während des Messbetriebs aufzuladen.

Eine besonders günstige Anbringung des Drehwahlschalters lässt sich beispielsweise dadurch realisieren, dass das Kopfteil im Wesentlichen aus wenigstens zwei Gehäusehälften besteht, wobei ein bezüglich der Längsachse des Prüfgerätes im Wesentlichen rechtwinklig herauskragender Drehwahlschalteraufnahmebereich integral mit einer der Gehäusehälften ausgebildet ist. Durch diese Maßnahme wird eine Vielzahl an Bauteile eingespart. Ferner können insbesondere die Halterungselemente, Aufnahmen weiterer Bestandteile wie beispielsweise die Aufnahme einer Beaufschlagungskugel des Drehwahlschalters, welche ein Folienpotentiometer beaufschlagt, und/oder Rastbestandteile integral mit einer der Gehäusehälften und/oder dem Drehwahlschalter ausgebildet werden.

Bevorzugt weist der herauskragende Drehwahlschalteraufnahmebereich einen verjüngten, sich nach außen vergrößernden Querschnittsbereich auf. Dieser verjüngte Bereich dient unter anderem der rotierbaren Lagerung des Kopfteils mit dem Basisteil. Ferner kann in den verjüngten Querschnittsbereich der Drehwahlschalteraufnahme ein separates Ringelement eingesetzt werden, welches mit weiteren für die Verschwenkung von Kopf- und Basisteil vorgesehenen Funktionen versehen werden kann. Dieses Ringelement weist eine Öffnung auf, damit es in den verjüngten Bereich durch temporäre Aufweitung des Ringes und anschließender, zumindest teilweise Zurückfederung des Ringes durch einen Memory-Effekt des den Ring bildenden Materials eine einfache Montage und Anbindung des Ringelementes an den verjüngten Querschnittsbereich der Drehwahlschalteraufnahme ermöglicht. Darüber hinaus ist es vorteilhaft, wenn das Ringelement wenigstens eine nach außen weisende Hervorhebung und/oder Ausnehmung aufweist, die im Zusammenwirken mit einem korrespondierenden Element eine Rastfunktion des Kopfteils bei der Verschwenkung relativ zum Basisteil schafft, wobei das korrespondierende Element beispielsweise integral mit wenigstens einem Gehäusebereich des Basisteils ausgebildet sein kann. Die Federfunktion des Rastelementes ist vorteilhafterweise in das Ringelement integriert, so dass dieses neben der Elastizität für die Aufweitung und des Zurückfederns des Ringes einen definierten Bereich am Umfang des Ringes umfasst. Dies kann beispielsweise durch zwei koaxial angeordnete Ringhülsenabschnitte erreicht werden, wobei die Ringhülsenabschnitte derart miteinander durch Stege verbunden sind, dass der äußere Ringabschnitt relativ zum inneren Ringabschnitt elastisch angebunden ist.

Eine weitere vorteilhafte Maßnahme betreffend das Ringelement ist es, wenn das Ringelement an seinen beiden die Öffnung definierenden Enden jeweils wenigstens einen im Wesentlichen radial zum Zentrum des Ringelementes weisenden Zapfen aufweist, der im Endmontagezustand in eine entsprechende Ausnehmung des verjüngten Bereiches einer Gehäuseschale eingreift. Die beschriebenen Zapfen des Ringelementes dienen einerseits dem zuverlässigen Verschluss des Ringelementes in seiner Endmontagestellung, als auch andererseits durch eine Zentrier- und Ausrichtungsfunktion eine definierte Ausrichtung des Ringes innerhalb des verjüngten Bereiches auf einfache Weise zu gewährleisten.

In Ausgestaltung der Erfindung steht der Drehwahlschalter mittelbar oder unmittelbar mit einem sich rechtwinklig zur Drehachse des Drehwahlschalters erstreckenden Folienpotentiometers in Wirkverbindung. Insbesondere die Verwendung eines Folienpotentiometers um die durch den Drehwahlschalter auszuwählenden Menüpunkte mittels gezielter Veränderung des Widerstandswertes und dem Abgreifen der Widerstandsänderung des Folienpotentiometers durch entsprechende Mittel die wiederum eine Zuordnung zu bestimmten Menüpunkten und/oder Messgrößen ausführen stellt eine einfache, Platz sparende sowie wenig Bauteile benötigende Realisierung einer Menüpunkt- oder Messbereichsauswahl innerhalb des Prüfgerätes Betreffend das Folienpotentiometer ist es ferner vorteilhaft, wenn das Zentrum des Folienpotentiometers koaxial zur Schwenkachse des Kopfteils/Basisteils ausgerichtet ist.

In einer vorteilhaften Ausführungsform besitzt das Kopf- und/oder das Basisteil eine u-förmige Ausnehmung zur Aufnahme des Basis- oder Kopfteils. Hierbei kann die Schwenkachse von Kopf- und Basisteil durch die Schenkel der u-förmigen Ausnehmung verlaufen. Die Schwenkachse von Kopf- und Basisteil kann im Wesentlichen rechtwinklig zur Längsachse des Prüfgerätes verlaufen. Vorteilhafterweise ist die Schwenkachse an einem Endbereich des Kopf- und/oder Basisteils angeordnet.

Vorteilhafterweise kann das Prüfgerät während seines Einsatzes durch ein Netzteil mit einer Netzspannung über die Schnittstelle gespeist werden und/oder im Prüfgerät eingesetzte Akkumulatoren aufgeladen werden. Das in dem verjüngten Querschnittsbereich der Drehwahlschalteraufnahme angesetzte Ringelement weist wenigstens eine nach außen weisende Hervorhebung und/oder Ausnehmung auf, die im Zusammenwirken mit einem korrespondierenden Element eine Rastfunktion des Kopfteils der Verschwenkung relativ zum Basisteil ausführt. Dieses korrespondierende Element ist vorzugsweise integral mit wenigstens einem Gehäusebereich des Basisteils ausgebildet. An den beiden die Öffnung definierenden Enden des Ringelementes sind jeweils wenigstens ein im Wesentlichen radial zum Zentrum des Ringelementes weisender Zapfen angeordnet, der im Endmontagezustand in eine entsprechende Ausnehmung des verjüngten Bereichs einer Gehäuseschale eingreift.

Das Zentrum des für den Drehwahlschalter verwendeten Folienpotentiometers verläuft koaxial zur Schwenkachse des Kopfteils relativ zum Basisteil.

Die an dem Ringelement angeformten Rasthervorhebungen und/oder Rastausnehmungen sind in vorgespannter Endmontagestellung auf einer durch das Zentrum des Ringelementes führenden Geraden angeordnet und im ausgebauten entspannten Zustand des Ringelementes nicht auf einer durch das Zentrum führenden Geraden liegend angeordnet.

Die Erfindung ist anhand von Ausführungsbeispielen in den Zeichnungsfiguren näher erläutert. Diese zeigen
- Fig. 1: eine perspektivische Darstellung des Prüfgerätes in einer ersten Tischstellung (Tischstellung I);
- Fig. 2: eine perspektivische Darstellung des Prüfgerätes in einer vertikalen Tragestellung;
- Fig. 3: eine perspektivische Darstellung des Prüfgerätes in einer zweiten Tischstellung (Tischstellung II);
- Fig. 4: eine perspektivische Darstellung des Drehwahlschalteraufnahmebereiches mit ausgebautem Ringelement;
- Fig. 5: eine perspektivische Schnittdarstellung des Folienpotentiometers und des Bestandteils des Drehwahlschalters;

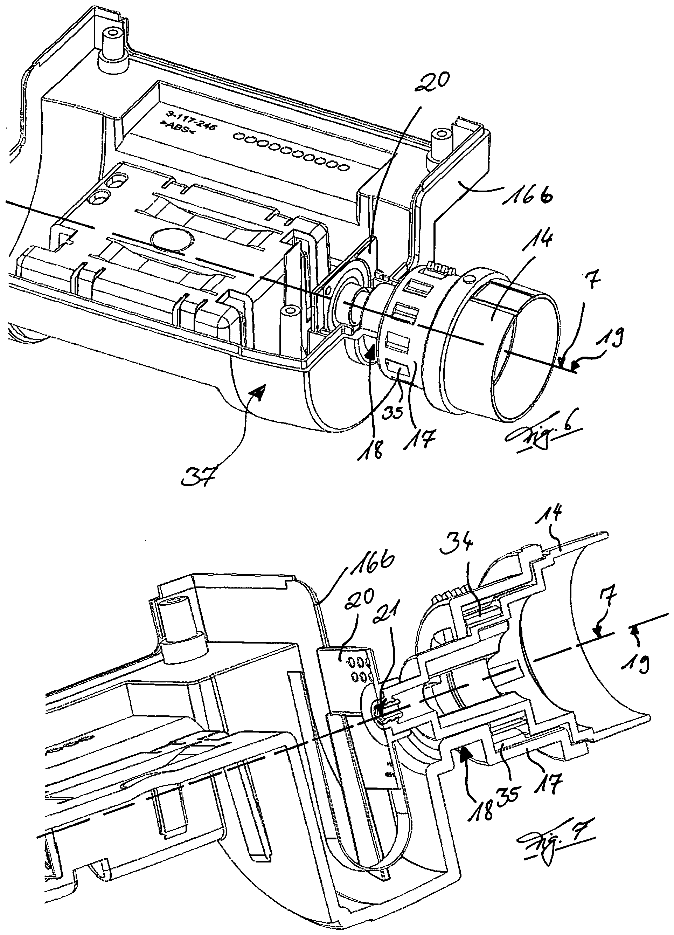

- Fig. 6: eine perspektivische Darstellung eines Gehäuseteils des Kopfteils mit einstückigem Drehwahlschalteraufnahmebereichs;
- Fig. 7: eine schematische Schnittdarstellung einer Kopfteilgehäusehälfte und des Drehwahlschalters;
- Fig. 8a,b: eine schematische perspektivische Darstellung des Ringelementes in Endmontagestellung (a) und entspannter ausgebauter Stellung (b).

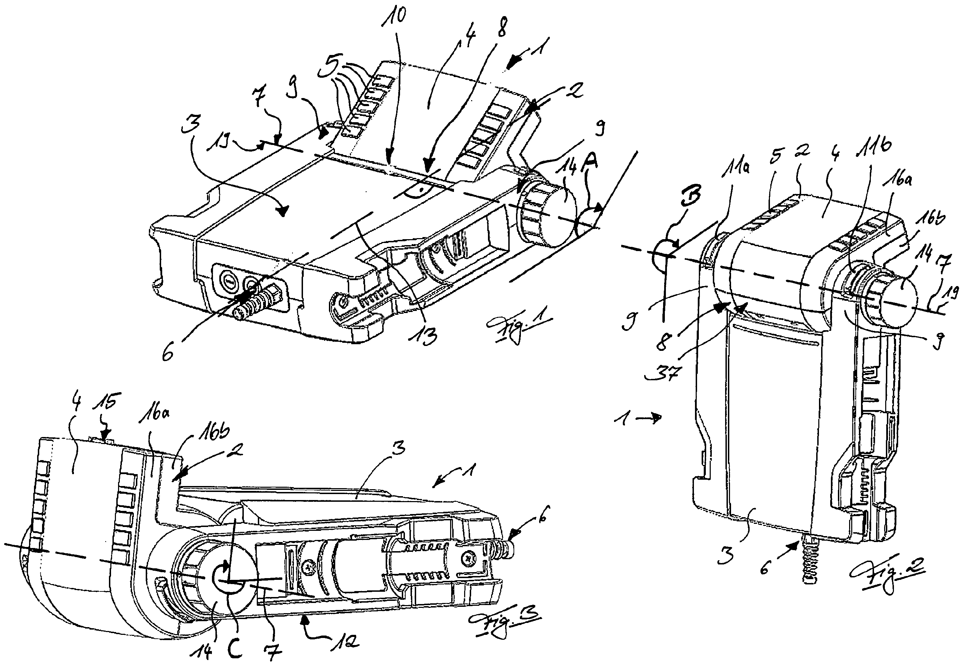

In Zeichnungsfigur 1 ist ein Prüfgerät 1 zum Messen von Spannungen, Strömen und dergleichen mit einem Kopfteil 2 sowie einem Basisteil 3 aufweist, wobei im Kopfteil 2 eine Anzeigeeinheit 4 und Bedienelemente 5 in Form von Tasten angeordnet sind. Ferner weist das Prüfgerät 1 eine Anschluss- und/oder eine Schnittstelle 6 zum Einleiten eines Messstroms auf, diese Schnittstelle 6 ist in der dargestellten Ausführungsform an einer dem Kopfteil 2 abgewandten Gehäuseseite des Basisteils 3 angeordnet. Die Schnittstelle 6 kann vorzugsweise als Messanschluss ausgebildet sein und im Bereich der Schnittstelle 6 Sicherungsaufnahmen aufweisen, vgl. Figur 1. Das Kopfteil 2 und das Basisteil 3 sind zueinander schwenkbeweglich gelagert, wobei die Schwenkachse 7 zumindest bereichsweise sowohl durch das Basisteil 3 als auch durch das Kopfteil 2 verläuft. Das Kopfteil 2 ist in einer u-förmigen Ausnehmung 8 des Basisteils 3 derart aufgenommen, dass die Schwenkachse 7 durch die Schenkel 9 und gleichzeitig an einem Endbereich 10 des Kopf- und Basisteils 2, 3 angeordnet ist. Wie gut aus der Zusammenschau der Figuren 1 - 3 ersichtlich ist, ist das Kopfteil 3 aus der Haupterstreckungsebene des Basisteils 3 herausschwenkbar. Dabei sind die wesentlichen Arbeitsstellungen abgebildet. Zeichnungsfigur 1 bildet eine erste Tischstellung (Tischstellung I), bei der das Kopfteil 2 einen Winkel von ca. 125° (vgl. Pfeil A) mit dem Basisteil 3 einschließt. In dieser Tischstellung I weist die Anschluss-/Schnittstelle 6 zum Anwender hin und die Anzeigeeinheit 4 ist durch die Verschwenkung des Kopfteils 2 derart schräg gestellt, dass diese komfortabel für den Bediener ablesbar ist. Gemäß Zeichnungsfigur 2 ist das Kopfteil 2 um ca. 160° (vgl. Pfeil B) verschwenkt, so dass, wenn das Messgerät über seine Gurtaufnahme 11a, 11b umgehängt ist, wiederum die Anzeigeeinheit 4 und die Bedienelemente 5 für die Bedienperson leicht abzulesen und auf einfache Weise bedienbar angeordnet sind. Wenn das Kopfteil 2 um ca. 270° (Pfeil C) relativ zum Basisteil 3 verschwenkt ist (Tischstellung II) kann das Prüfgerät auf dem "Bauch" 12 liegend auf einem Tisch abgestellt werden, vgl. Zeichnungsfigur 3. In dieser Tischstellung II ist die Anzeigeeinheit 4 wie auch die Bedienelemente 5 nahe an der Bedienperson und können damit auf einfache Weise bedient und abgelesen werden. Diese Stellung eignet sich insbesondere bei einem längeren, kein Umstecken der Messstrippen erfordernden Einsatz des Prüfgerätes 1.

Wie aus den Zeichnungsfiguren 1 - 3 ersichtlich, ist die Schwenkachse 7 im Wesentlichen rechtwinklig zur Längsachse 13 des Prüfgerätes 1 ausgerichtet.

Neben den mit den Bezugszeichen 5 beschriebenen Bedienelementen 5 ist am seitlichen Gehäusebereich des Prüfgerätes 1 ein Drehwahlschalter 14 angeordnet, der im Bereich des Kopfteils 2 platziert ist. Unabhängig von der Schwenkstellung des Kopfteils 2 relativ zum Basisteil 3 führt der Drehwahlschalter 14 ausschließlich eine rotatorische Bewegung aus, er wandert somit nicht mit translatorischen Bewegungsanteilen mit einem der Teile 2, 3 mit. Dadurch, dass der Drehwahlschalter 14 so gesehen ortsfest an das Prüfgerät angebunden ist, ist eine "blinde" Bedienung des Drehwahlschalters 14 für die Bedienperson ermöglicht.

Neben der Anschluss-/Schnittstelle 6 für den Mess- bzw. Leistungsstrom sind weitere Schnittstellen 15 für beispielsweise ein Netzteil und/oder Datenein- oder - auslesevorrichtungen im Bereich des Kopfteils 2 angeordnet. Dies wird vor allem durch die induktive, kabellose Kopplung der Ströme zwischen dem Kopfteil 2 und dem Basisteil 3 ohne eine Gefahr für den Bediener zu bilden, realisiert.

Das Kopfteil 2 besteht im Wesentlichen aus zwei Gehäusehälften 16a, b, wobei an der Gehäusehälfte 16b ein im Wesentlichen rechtwinklig zur Längsachse 13 des Prüfgerätes 1 herauskragender Drehwahlschalteraufiiahmebereich 17 integral mit der Gehäusehälfte 16b ausgebildet ist, vgl. Zeichnungsfiguren 4, 6 und 7. Dabei weist der herauskragende Drehwahlschalteraufnahmebereich 17 einen verjüngten, sich nach außen vergrößernden Querschnittsbereich 18 auf. Ferner weist der Kopfteil 2 einen konvexen Gehäusebereich 37 auf, der eine kompakte Bauform ermöglicht. Die Drehachse 19 des Drehwahlschalters 14 ist dabei koaxial zur Schwenkachse 7 des Kopf- und Basisteils 2, 3 ausgerichtet. Zusätzlich ist ein Folienpotentiometer 20 in dem Prüfgerät 1 vorgesehen, das die jeweilige Stellung des Drehwahlschalters 14 detektiert. Das Zentrum 21 des Folienpotentiometers ist dabei koaxial zur Schwenkachse 7 des Kopfteils 2 und des Basisteils 3 und gleichzeitig koaxial zur Drehachse 19 des Drehwahlschalters 14 ausgerichtet. Wie in Zeichnungsfigur 5 dargestellt, ist der Drehwahlschalter 14 derart ausgebildet, dass eine außerzentrisch gelagerte vorgespannte Kugel 22 auf der Leiterbahn 23 des Folienpotentiometers 20 während der Verdrehung des Drehwahlschalters 14 auf dieser Leiterbahn 23 konstant beaufschlagend bewegt wird. Diese damit einhergehende Widerstandsveränderung, die vom Folienpotentiometer 20 abgegeben wird, kann durch entsprechende Hard- und Softwarekomponenten (nicht dargestellt) weiterverarbeitet werden, so dass damit die jeweiligen Messparameter (Menüsteuerung) des Prüfgerätes 1 einstellbar sind.

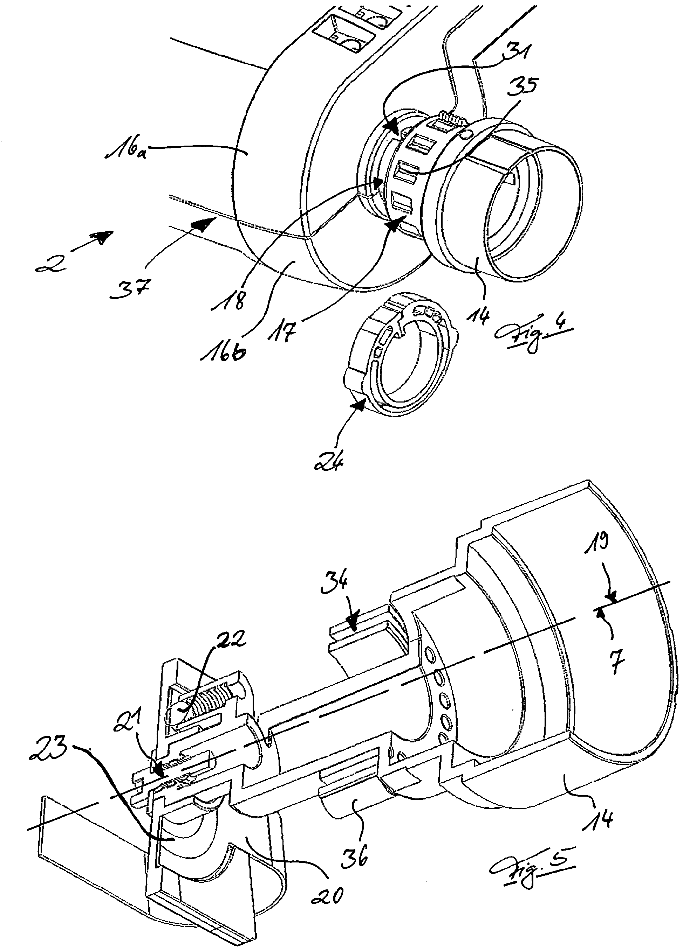

Das in Zeichnungsfigur 4 dargestellte Ringelement 24 wird in den verjüngten Querschnittsbereich 18 der Drehwahlschalteraufnahme 17 eingesetzt. Für die weiteren Details des Ringelementes 24 wird auf die Zeichnungsfiguren 8a und 8b Bezug genommen. Dabei ist erkennbar, dass das Ringelement 24 an seiner äußeren Umfangsfläche 2 Rasthervorhebungen 25 aufweist, die im Endmontagezustand mit einem korrespondierenden Element (nicht dargestellt) eine Rastfunktion während des Verschwenkens des Kopfteils 2 mit dem Basisteil 3 ausführt. Wie aus den Zeichnungsfiguren 8a und 8b ersichtlich, sind die Rasthervorhebungen 25 an einem äußeren Kreisringmantel 26 ausgebildet und dieser Kreisringmantel 26 derart mit einem inneren Kreisringmantel 27 mit Stegen 32 verbunden, dass diese Verbindung ein elastisches, federndes Auslenken der Rasthervorhebungen 25 erlaubt. Ferner weist das Ringelement 24 an seinen beiden die Öffnung 28 definierenden Enden jeweils einen sich radial zum Zentrum 29 des Ringelementes 24 erstreckende Zapfen 30a, b auf, die im Endmontagezustand des Ringelementes 24 in eine entsprechende Ausnehmung 31 (vgl. Figur 4) des verjüngten Bereiches 18 einer oder mehrerer Gehäuseschalen 16a, 16b eingreift und damit sowohl eine Zentrierfunktion, eine Verdrehsicherungsfunktion, als auch eine den Ring 24 geschlossen haltende Funktion ausführt.

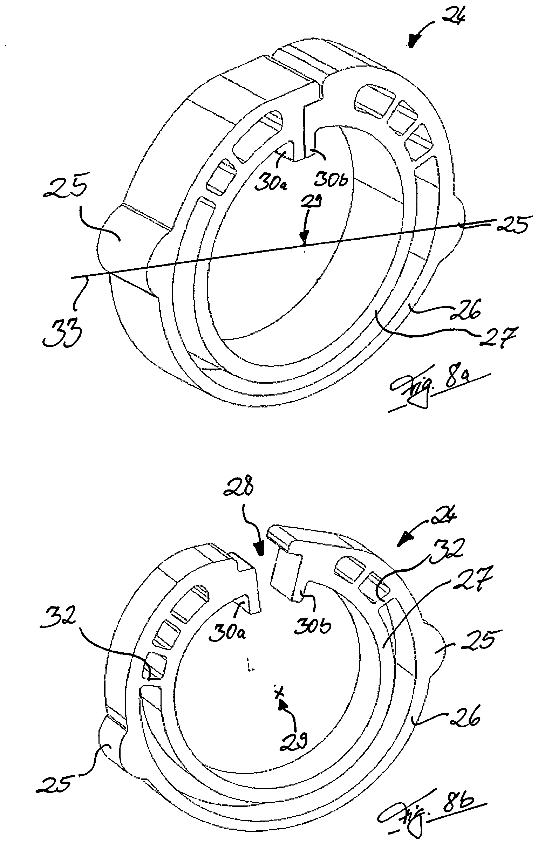

Die Rasthervorhebungen 25 sind derart angeordnet, dass sie im Endmontagezustand (Fig. 8a) auf einer durch das Zentrum 29 des Ringelementes 24 liegenden Geraden 33 liegen und im entspannten Zustand (Fig. 8b) nicht auf einer durch das Zentrum 29 liegenden Geraden liegen.

Eine Verrastung des Drehwahlschalters 14 ist mittels eines offenen oder geschlossenen Ringes 34 nach Art des Ringelementes 24 realisiert, dessen Rastnasen 36 beaufschlagen die an der Außenseite der Drehwahlschalteraufnahme 17 erkennbaren Sicken 35. Damit ist ein Bestandteil der Rastfunktion des Drehwahlschalters 14 integral mit der Drehwahlschalteraufnahme 17 des Kopfgehäuseteils 16b ausgebildet.

### BEZUGSZEICHENLISTE

- 1: Prüfgerät
- 2: Kopfteil
- 3: Basisteil
- 4: Anzeigeeinheit
- 5: Bedienelemente
- 6: Anschluß-/Schnittstelle
- 7: Schwenkachse
- 8: Ausnehmung
- 9: Schenkel v. 8
- 10: Endbereich
- 11a, 11b: Gurtaufnahmen
- 12: Bauch v. 1
- 13: Längsachse v. 1
- 14: Drehwahlschalter
- 15: Schnittstelle
- 16a, 16b: Gehäusehälfte v. 2
- 17: Drehwahlschalteraufnahmebereich
- 18: Querschnittsbereich v. 17
- 19: Drehachse v. 14
- 20: Folienpotentiometer
- 21: Zentrum v. 20
- 22: Kugel
- 23: Leiterbahn v. 20
- 24: Ringelement
- 25: Rasthervorhebungen
- 26: Kreisringmantel v. 24
- 27: Kreisringmantel v. 24
- 28: Öffnung v. 24
- 29: Zentrum v. 24
- 30a, 30b: Zapfen
- 31: Ausnehmung v. 18
- 32: Steg
- 33: Gerade
- 34: Ring
- 35: Sicke v. 17
- 36: Rastnase v. 34
- 37: Gehäusebereich v. 2

## Patentansprüche

1. Prüfgerät zum Messen von Spannungen und Strömen, aufweisend ein mit einer Anzeigeeinheit (4) versehenes Kopfteil (2) sowie ein Basisteil (3), das wenigstens eine Anschluss- und/oder eine Schnittstelle (6) zum Einleiten eines Messstroms umfasst, das Kopfteil (2) und das Basisteil (3) zueinander schwenkbeweglich gelagert sind und die Schwenkachse (7) zumindest bereichsweise sowohl durch das Basisteil (3) als auch durch das Kopfteil (2) verläuft, **dadurch gekennzeichnet, dass** die Drehachse (19) eines Drehwahlschalters (14) koaxial zur Schwenkachse (7) des Kopf- und Basisteils (2, 3) verläuft, wobei mit dem Drehwahlschalter (14) die zu messende Messgröße auswählbar ist und mit weiteren Bedienelementen ein gezielter Messbereich auswählbar ist.

2. Prüfgerät nach Anspruch 1, **dadurch gekennzeichnet, dass** das Kopf- oder Basisteil (2, 3) in wenigstens einer dem Basis- oder Kopfteil zugeordneten Seite (10) einen konvexen Gehäusebereich (37) aufweist, wobei dem konvexen Gehäusebereich (37) ein zumindest bereichsweise entsprechender konkaver Gehäusebereich an dem dem konvexen Gehäusebereich (37) gegenüberstehenden Kopf- oder Basisteil (2, 3) zugeordnet ist.

3. Prüfgerät nach Anspruch 1 oder 2, **dadurch gekennzeichnet, dass** das Kopfteil (2) aus der Haupterstreckungsebene des Basisteils (3) herausschwenkbar ist, wobei das Kopfteil (2) sich ausgehend von einer wenigstens einen 90°-Winkel einschließenden ersten Position (Tischstellung I) in eine zweite Position um wenigstens 190° (Trageposition) verschwenken lässt und darüber hinaus in eine wenigstens 270° verschwenkte Position (Tischstellung II) relativ zum Basisteil (3) verschwenkbar ist.

4. Prüfgerät nach einem der vorhergehenden Ansprüche, **dadurch gekennzeichnet, dass** im Bereich der Drehlagerung des Drehwahlschalters (14) Dichtelemente angeordnet sind.

5. Prüfgerät nach einem der vorhergehenden Ansprüche, **dadurch gekennzeichnet, dass** der Drehwahlschalter (14) in axialer und/oder radialer Richtung nach Art eines Tasters betätigbar ist.

6. Prüfgerät nach einem der vorhergehenden Ansprüche, **dadurch gekennzeichnet, dass** zumindest ein Teil der für die Strom- bzw. Spannungsmessungen notwendigen Informationen über eine induktive Koppelung, insbesondere durch Transformatoren kabellos von dem Basisteil (3) zum Kopfteil (2) und/oder umgekehrt übertragbar sind.

7. Prüfgerät nach Anspruch 6, **dadurch gekennzeichnet, dass** im Bereich des Kopfteils (2) Schnittstellen (15) angeordnet sind.

8. Prüfgerät nach einem der vorhergehenden Ansprüche, **dadurch gekennzeichnet, dass** das Kopfteil (2) im Wesentlichen aus wenigstens zwei Gehäusehälften (16a, 16b) besteht, wobei wenigstens bereichsweise ein bezüglich der Längsachse (13) des Prüfgeräts (1) im wesentlichen rechtwinklig herauskragender Drehwahlschalteraufnahmebereich (17) integral mit einer der Gehäusehälften (16a, 16b) ausgebildet ist.

9. Prüfgerät nach Anspruch 8, **dadurch gekennzeichnet, dass** der herauskragende Drehwahlschalteraufnahmebereich (17) einen verjüngten, sich nach außen vergrößernden Querschnittsbereich (18) aufweist.

10. Prüfgerät nach Anspruch 9, **dadurch gekennzeichnet, dass** in den verjüngten Querschnittsbereich (18) des Drehwahlschalteraufnahmebereichs (17) ein Ringelement (24) angesetzt wird, das eine Öffnung aufweist.

11. Prüfgerät nach Anspruch 10, **dadurch gekennzeichnet, dass** das Ringelement (24) federnd ausgebildet ist.

12. Prüfgerät nach einem der vorhergehenden Ansprüche, **dadurch gekennzeichnet, dass** der Drehwahlschalter (14) mittelbar oder unmittelbar mit einem rechtwinklig zur Drehachse (19) des Drehwahlschalters (14) angeordneten Folienpotentiometer (20) in Wirkverbindung steht.

13. Prüfgerät nach einem der vorhergehenden Ansprüche, **dadurch gekennzeichnet, dass** der Drehwahlschalter (14) bei Verschwenken des Kopfteils (2) relativ zum Basisteil (3) ausschließlich rotatorische und keine translatorischen Bewegungsanteile ausführt.

14. Prüfgerät nach einem der vorhergehenden Ansprüche, **dadurch gekennzeichnet, dass** abhängig von der Schwenkstellung des Kopfteils (2) relativ zum Basisteil (3) wenigstens zwei unterschiedliche Display-Menü-Einstellungen voreingestellt ausgebbar sind.

## Claims

1. Test device for measuring voltages and currents, having a head part (2), which is provided with a display unit (4), and also a base part (3), which comprises at least one connection point and/or an interface (6) for introducing a measurement current, the head part (2) and the base part (3) are mounted such that they can pivot in relation to one another, and the pivot axis (7) runs at least in regions both through the base part (3) and also through the head part (2), **characterized in that** the rotation axis (19) of a rotary selector switch (14) runs coaxially in relation to the pivot axis (7) of the head and base part (2, 3), wherein the measurement variable to be measured can be selected by way of the rotary selector switch (14) and a targeted measurement range can be selected by way of further operator control elements.

2. Test device according to Claim 1, **characterized in that** the head or base part (2, 3) has a convex housing region (37) in at least one side (10) which is associated with the base or head part, wherein a concave housing region, which corresponds at least in regions, on the head or base part (2, 3) which is situated opposite the convex housing region (37) is associated with the convex housing region (37).

3. Test device according to Claim 1 or 2, **characterized in that** the head part (2) can be pivoted out of the main plane of extent of the base part (3), wherein the head part (2) can be pivoted, starting from a first position (table position I) which forms an at least 90° angle, through at least 190° into a second position (supporting position) and furthermore into a position pivoted through at least 270° (table position II) relative to the base part (3).

4. Test device according to one of the preceding claims, **characterized in that** sealing elements are arranged in the region of the rotary bearing of the rotary selector switch (14).

5. Test device according to one of the preceding claims, **characterized in that** the rotary selector switch (14) can be operated in the axial and/or radial direction in the manner of a pushbutton.

6. Test device according to one of the preceding claims, **characterized in that** at least some of the information required for the current or voltage measurements can be transmitted via inductive coupling, in particular by transformers in a cable-free manner, from the base part (3) to the head part (2) and/or vice versa.

7. Test device according to Claim 6, **characterized in that** interfaces (15) are arranged in the region of the head part (2).

8. Test device according to one of the preceding claims, **characterized in that** the head part (2) is substantially composed of at least two housing halves (16a, 16b), wherein a rotary selector switch receiving region (17), which projects substantially at a right angle with respect to the longitudinal axis (13) of the test device (1), is integrally formed with one of the housing halves (16a, 16b) at least in regions.

9. Test device according to Claim 8, **characterized in that** the projecting rotary selector switch receiving region (17) has a tapered cross-sectional region (18) which increases in size towards the outside.

10. Test device according to Claim 9, **characterized in that** a ring element (24), which has an opening, is fitted into the tapered cross-sectional region (18) of the rotary selector switch receiving region (17).

11. Test device according to Claim 10, **characterized in that** the ring element (24) has a spring action.

12. Test device according to one of the preceding claims, **characterized in that** the rotary selector switch (14) is indirectly or directly operatively connected to a film potentiometer (20) which is arranged at a right angle in relation to the rotation axis (19) of the rotary selector switch (14).

13. Test device according to one of the preceding claims, **characterized in that** the rotary selector switch (14) executes only rotary movement components and no translatory movement components when the head part (2) is pivoted relative to the base part (3).

14. Test device according to one of the preceding claims, **characterized in that** at least two different display menu settings can be output in a preset manner depending on the pivot position of the head part (2) relative to the base part (3).

## Revendications

1. Appareil de contrôle destiné à mesurer des tensions et des courants, comportant une partie supérieure (2) munie d'une unité de signalisation (4), ainsi qu'une partie de base (3), qui comprend au moins un point de connexion et/ou point d'interface (6) pour l'introduction d'un courant de mesure, la partie supérieure (2) et la partie de base (3) étant logées en étant mobiles en pivotement l'une par rapport à l'autre et l'axe de pivotement (7) s'écoulant au moins par endroits à travers la partie de base (3) ainsi qu'également à travers la partie supérieure (2), **caractérisé en ce que** l'axe de rotation (19) d'un sélectionneur rotatif (14) s'écoule de manière coaxiale par rapport à l'axe de pivotement (7) de la partie supérieure et de la partie de base (2, 3), à l'aide du sélectionneur rotatif (14) la grandeur de mesure qui doit être mesurée étant sélectionnable et à l'aide d'éléments de commande supplémentaires, une plage de mesure ciblée étant sélectionnable.

2. Appareil de contrôle selon la revendication 1, **caractérisé en ce que** la partie supérieure ou la partie de base (2, 3) comporte dans au moins un côté (10) associé à la partie de base ou à la partie supérieure une zone de boîtier (37) convexe, à la zone de boîtier (37) convexe étant associée une zone de boîtier concave correspondante au moins par endroits sur la partie supérieure ou partie de base (2, 3) faisant face à la zone de boîtier (37) convexe.

3. Appareil de contrôle selon la revendication 1 ou 2, **caractérisé en ce que** la partie supérieure (2) est susceptible de pivoter hors du plan d'extension principal de la partie de base (3), la partie supérieure (2) se laissant pivoter à partir d'une première position incluant au moins un angle de 90° (position de table I), dans une deuxième position d'au moins 190° (position porteuse) et au-delà de celle-ci, dans une position pivotée d'au moins 270° (position de table II) par rapport à la partie de base (3).

4. Appareil de contrôle selon l'une quelconque des revendications précédentes, **caractérisé en ce que**, dans la zone du logement en rotation du sélectionneur rotatif (14) sont placés des éléments d'étanchéité.

5. Appareil de contrôle selon l'une quelconque des revendications précédentes, **caractérisé en ce que** dans la direction axiale et/ou radiale, le sélectionneur rotatif (14) peut être actionné à la manière d'un palpeur.

6. Appareil de contrôle selon l'une quelconque des revendications précédentes, **caractérisé en ce qu'**au moins une partie des informations nécessaires pour les mesures du courant ou des tensions est susceptible d'être transmise sans fil, par l'intermédiaire d'un couplage inductif, notamment via des transformateurs, de la partie de base (3) vers la partie supérieure (2) et/ou inversement.

7. Appareil de contrôle selon la revendication 6, **caractérisé en ce que** dans la zone de la partie supérieure (2) sont placées des interfaces (15).

8. Appareil de contrôle selon l'une quelconque des revendications précédentes, **caractérisé en ce que** la partie supérieure (2) est constituée sensiblement d'au moins deux moitiés de boîtier (16a, 16b), au moins par endroits, une zone de logement du sélectionneur rotatif (17) qui saillit sensiblement à angle droit par rapport à l'axe longitudinal (13) de l'appareil de contrôle (1) étant conçue en intégralité avec l'une des moitiés de boîtier (16a, 16b).

9. Appareil de contrôle selon la revendication 8, **caractérisé en ce que** la zone saillante de logement du sélectionneur rotatif (17) comporte une zone de section transversale (18) rétrécie, s'agrandissant vers l'extérieur.

10. Appareil de contrôle selon la revendication 9, **caractérisé en ce que** dans la zone de section transversale rétrécie (18) de la zone de logement du sélectionneur rotatif (17), on fixe un élément annulaire (24) qui comporte un orifice.

11. Appareil de contrôle selon la revendication 10, **caractérisé en ce que** l'élément annulaire (24) est conçu en version résiliente.

12. Appareil de contrôle selon l'une quelconque des revendications précédentes, **caractérisé en ce que**, le sélectionneur rotatif (14) est en interaction indirecte ou directe avec un potentiomètre à film plastique (20) placé à angle droit par rapport à l'axe de rotation (19) du sélectionneur rotatif (14) .

13. Appareil de contrôle selon l'une quelconque des revendications précédentes, **caractérisé en ce que** lors du pivotement de la partie supérieure (2) par rapport à la partie de base (3), le sélectionneur rotatif (14) réalise exclusivement des composantes de mouvement en rotation et non pas en translation.

14. Appareil de contrôle selon l'une quelconque des revendications précédentes, **caractérisé en ce qu'**en fonction de la position en pivotement de la partie supérieure (2) par rapport à la partie de base (3), au moins deux réglages différents du menu de l'écran peuvent être édités de manière préalablement réglée.
